# EUROPEAN PATENT APPLICATION

(11) **EP 4 679 982 A2**
(43) Date of publication of application: **14.01.2026**
(21) Application number: 24807350.4
(22) Date of filing: 29.03.2024
(51) Int. Cl.: H10H 20/857, H01L 25/075, H10H 20/856, C08L 63/00

(54) **CONNECTION FILM AND DISPLAY PANEL INCLUDING SAME**

(30) Priority: 12.05.2023 KR 20230061846
(71) Applicant: Samsung Electronics Co., Ltd., Suwon-si, Gyeonggi-do 16677 (KR)
(72) Inventor: JUNG, Jonghoon, Suwon-si Gyeonggi-do 16677 (KR); KIM, Jinyoung, Suwon-si Gyeonggi-do 16677 (KR); MIN, Sungyong, Suwon-si Gyeonggi-do 16677 (KR); LEE, Changjoon, Suwon-si Gyeonggi-do 16677 (KR)
(74) Representative: Appleyard Lees IP LLP
(86) International application number: PCT/KR2024/004115
(87) International publication number: WO 2024/237469

(57) **Abstract**

Disclosed are a connection film connecting a substrate and a plurality of light emitting diodes, and a display panel including the same. The connection film may include a sheet having a black-shade color, and a plurality of conductive adhesive members provided to the sheet at intervals.

## Description

### [TECHNICAL FIELD]

This disclosure relates to a connection film connecting a light emitting diode and a substrate, and a display panel including the same.

### [BACKGROUND ART]

For an element to be mounted on a substrate, a conductible connection material may be disposed between the element and the substrate. The connection material may include an anisotropic conductive film including a plurality of conductive balls, and a conductive adhesive. The conductive adhesive may be less expensive than the anisotropic conductive film, but may exhibit no optical properties and not be suitable as a material for connecting a light emitting diode to the substrate of a display panel.

### [DISCLOSURE OF INVENTION]

### [SOLUTION TO PROBLEM]

Provided is a connection film that may be inexpensive and secure ease of manufacturing, and a display panel including the same.

According to one or more embodiments, a connection film configured to connect a substrate and a plurality of light emitting diodes may include: a sheet having a black-shade color; and a plurality of conductive adhesive members provided at intervals on the sheet.

The plurality of conductive adhesive members may be provided in a grid pattern on the sheet.

**A** surface area of each of the plurality of conductive adhesive members may be less than a surface area of a substrate pad on the substrate and less than a surface area of an electrode pad on one of the plurality of light emitting diodes.

The surface area of each of the plurality of conductive adhesive members may be 30% to 80% of a minimum area among the surface area of the substrate pad and the surface area of the electrode pad.

Each of the plurality of conductive adhesive members may have a curing temperature that is less than 200°C, and have a resistance value, after curing, is in a range of 0.1 ohms to 20 ohms.

Each of the plurality of conductive adhesive members may include: epoxy resin; and conductive materials in the epoxy resin, where the conductive materials include at least one of gold (Au), silver (Ag), carbon (C), copper (Cu), nickel (Ni), aluminum (Al), indium (In), or tin (Sn).

The sheet may have a luminosity in a range of 0.1 to 30.

According to one or more embodiments, the sheet may include a plurality of openings, where the connection film further includes: an insulation resin having a gray-shade color and provided in the plurality of openings; and a reflective member along an edge of the insulation resin and having a size that is less than a size of one of the plurality of conductive adhesive members.

The reflective member may include a plurality of glass balls.

The insulation resin may have a luminance property in which a brightness of each of red, green, and blue (RGB) is in a range of 1 < RGB < 100.

According to one or more embodiments, a display panel may include a substrate, a connection film attached to the substrate, and a light emitting diode connected to the substrate by the connection film.

The connection film may include a sheet having a black-shade color; and a conductive adhesive member provided to the sheet at intervals, and electrically connecting a plurality of substrate pads of the substrate with a plurality of electrode pads of the light emitting diode.

According to one or more embodiments, as for the display panel, a plurality of openings may be further included in the sheet. The connection film may further include an insulation resin having a gray-shade color and disposed in the plurality of openings, and a reflective member including

### [BRIEF DESCRIPTION OF DRAWINGS]

FIG. 1 is a cross-sectional view illustrating a display panel according to one or more embodiments;
FIG. 2 is a plan view illustrating a connection film according to one or more embodiments;
FIG. 3 is a cross-sectional view illustrating a connection film along A-A' in FIG. 2 according to one or more embodiments;
FIG. 4 is a view illustrating a substrate provided with a first substrate pad and a second substrate pad according to one or more embodiments;
FIG. 5 is a view illustrating a light emitting diode provided with a first electrode pad and a second electrode pad according to one or more embodiments;
FIG. 6 is a view showing an example a conductive adhesive member of a connection film, which is deformed from a non-conductible state to a conductible state based on thermal compression according to one or more embodiments;
FIGS. 7, 8, 9, and 10 are views illustrating a manufacturing process of a connection film according to one or more embodiments;
FIG. 11 is a plan view showing an example of an attachment of a connection film onto a substrate according to one or more embodiments;
FIG. 12 is a cross-sectional view showing an example of an attachment of a connection film onto a substrate according to one or more embodiments;
FIG. 13 is a plan view showing an example of a transfer of a light emitting diode onto a connection film according to one or more embodiments;
FIG. 14 is a cross-sectional view illustrating a light emitting diode transferred onto a connection film according to one or more embodiments;
FIG. 15 is a cross-sectional view illustrating a display panel according to one or more embodiments;
FIG. 16 is an enlarged view illustrating portion B in FIG. 15 according to one or more embodiments;
FIG. 17 is a cross-sectional view illustrating a connection film according to one or more embodiments;
FIG. 18 is a view showing an example of a provision of a touch screen to a display panel according to one or more embodiments;
FIG. 19 is a cross-sectional view illustrating a display panel according to one or more embodiments;
FIG. 20 is a cross-sectional view illustrating a connection film according to one or more embodiments;
FIGS. 21, 22, 23, 24, 25, 26 and 27 are views showing a manufacturing process of a connection film according to one or more embodiments;
FIG. 28 is a cross-sectional view illustrating a light emitting diode transferred onto a connection film according to one or more embodiments;
FIG. 29 is a cross-sectional view illustrating a display panel according to one or more embodiments; and
FIG. 30 is a block diagram illustrating a display device according to one or more embodiments.

### [MODE FOR INVENTION]

Hereafter, various example embodiment are specifically described with reference to accompanying drawings. One or more embodiments set forth herein may be modified in various different forms. Specific embodiments are illustrated in the drawings, and specifically described in detailed description. However, the embodiments illustrated in the drawings are not intended to limit the technical spirit of the disclosure, and rather, are provided for a better understanding of various embodiments. Accordingly, it is to be understood that the technical scope of the disclosure is not limited to the embodiments and that the embodiments are interpreted as including all equivalents or alternatives included in the technical spirit and scope of the disclosure.

In the disclosure, terms including ordinal numbers such as "1st", "2nd", "first", or "second", and the like may be used to refer to various elements but not intended to limit the elements. The terms are merely used to differentiate one element form another. In the disclosure, terms such as "comprise," "include," "have" and the like are used to indicate the presence of stated features, numbers, steps, operations, elements, components or a combination thereof, and do not imply exclusion of the presence or addition of one or more different features, numbers, steps, operations, elements, components or a combination thereof. Based on one element referred to as being "coupled with/to or connected with/to" another, it is to be understood that one element may be connected to another element directly or through yet another element (e.g., a third element). On the other hand, based on one element referred to as being "directly coupled with/to" or "directly connected with/to" another element, it is to be understood that yet another element (e.g., a third element) is not present between one element and another element. In the disclosure, the expression "identical" may denote including a difference to the degree that a machining error range is considered as well as denoting complete identicalness. In describing the disclosure, in case detailed descriptions of known functions or configurations to which the disclosure pertains make the gist of the disclosure unnecessarily vague, detailed descriptions thereof are reduced or avoided.

Hereafter, example embodiments of the disclosure are specifically described with reference to the drawings such that those skilled in the art may implement the embodiment easily. However, the embodiments may be implemented in various different forms, and embodiments are not limited to the embodiments set forth herein.

Hereafter, a display module and a display device including the display module according to one or more embodiments are described with reference to the drawings.

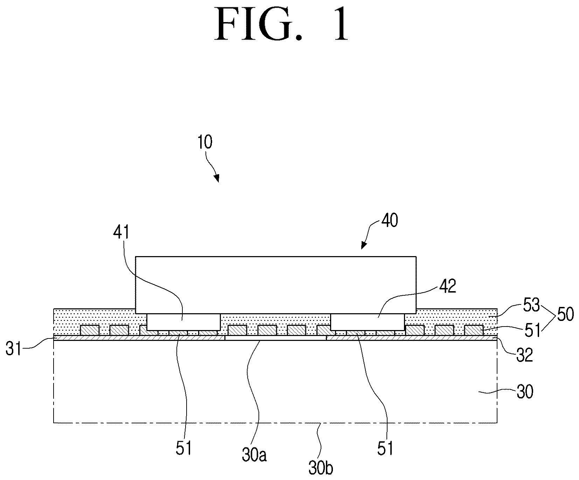

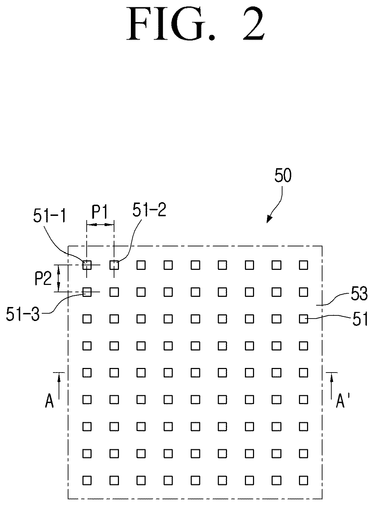

FIG. 1 is a cross-sectional view illustrating a display panel according to one or more embodiments. FIG. 2 is a plan view illustrating a connection film according to one or more embodiments.

According to one or more embodiments, a display panel 10 may be a curved display panel where a flat display panel or screen has a predetermined curvature.

Referring to FIG. 1, the display panel 10 may include a substrate 30, a connection film 50 provided to the substrate 30, and a plurality of light emitting diodes 40 connected electrically and physically to the substrate 30 by the connection film 50.

According to one or more embodiments, the plurality of lighting-emitting diodes 40 are provided to the substrate 30, but for convenience of description, FIG. 1 shows only one light emitting diode 40 on the substrate 30.

According to one or more embodiments, the substrate 30 may be a glass substrate, a synthetic resin-based (e.g., polyimide (PI), polyethylene terephthalate (PET), polyethersulfone (PES), polyethylene naphthalate (PEN), polycarbonate (PC) and the like) substrate having flexibility, or a ceramic substrate.

According to one or more embodiments, a TFT layer including a thin film transistor (TFT) may be provided on a first surface 30a of the substrate 30. The TFT provided in the TFT layer, for example, may be a low-temperature polycrystalline silicon (LTPS) TFT, a low-temperature polycrystalline oxide (LTPO) TFT, an oxide TFT, a Si (polysilicon, a-silicon) TFT, an organic TFT, or a graphene TFT. In the Si wafer CMOS process, a P-type or an N-type MOSFET may only be made and applied to the TFT.

According to one or more embodiments, the TFT layer of the substrate 30 may be integrally formed with the first surface 30a of the substrate 30, or may be manufactured in a separate film form and attached to the first surface 30a of the substrate 30.

According to one or more embodiments, a power supply circuit supplying power to a TFT circuit, a data driving driver, a gate driving driver or a timing controller controlling each of the driving drivers may be provided on a second surface 30b of the substrate 30.

According to one or more embodiments, the first surface 30a of the substrate 30 may be divided into an active area and a non-active area. The active area may be an area occupied by the TFT layer, out of the entire area of the first surface 30a of the substrate 30. The non-active area may be an area excluding the active area from the entire area of the first surface 30a of the substrate 30. An edge area of the substrate 30 may be an outermost area of the substrate. For example, the edge area of the substrate 30 may include an area corresponding to the lateral surface of the substrate, a partial area of the first surface30a of the substrate 30, which is adjacent respectively to the lateral surface, and a partial area of the second surface 30b of the substrate 30. In the edge area of the substrate 30, a plurality of lateral-surface wirings electrically connecting a TFT circuit on the first surface 30a of the substrate 30, and a driving circuit on the second surface 30b of the substrate 30 may be disposed.

According to one or more embodiments, the TFT layer in which the TFT circuit is formed may be omitted from the substrate 30. In this case, a plurality of micro IC chips functioning as a TFT circuit may be mounted on the first surface 30a of the substrate 30. At this time, a (the) plurality of micro IC chips may be electrically connected with the plurality of light emitting diodes 40 arranged on the first surface 30a of the substrate 30 through a wirings.

According to one or more embodiments, as for the substrate 30, a plurality of pixels may be arranged on the TFT layer. Each of the pixels may be driven by the TFT circuit. One pixel may include at least two or more light emitting diodes 40 that emit light of different colors. In the disclosure, one light emitting diode 40 may be referred to as one sub pixel.

According to one or more embodiments, the light emitting diodes 40 may be inorganic light emitting diodes having a size less than or equal to 100 µm. The inorganic light emitting diodes may be micro LEDs or mini LEDs.

According to one or more embodiments, the light emitting diode 40 may be configured in a flip chip form in which a first electrode pad 41 (e.g., an anode electrode pad) and a second electrode pad (e.g., a cathode electrode pad) are disposed on a surface opposite to a light emitting surface.

According to one or more embodiments, the connection film 50 may be laminated on the first surface 30a of the substrate 30 before the plurality of light emitting diodes 40 is transferred to the substrate 30.

According to one or more embodiments, the connection film 50 may connect the substrate 30 and the plurality of light emitting diodes 40 electrically and physically. For example, the connection film 40 may include a conductive material to electrically connect the electrode pads (the first electrode pad 41 and the second electrode pad 42) of the light emitting diode 40, and electrode pads (a first substrate pad 31 and a second substrate pad 32) of the substrate 30 corresponding to the electrode pads of the diode 40.

According to one or more embodiments, the connection film 50 may include a material having an adhesive force. In the case where the plurality of light emitting diodes 40 transferred to the substrate 30 is thermally compressed, the lower portions of the plurality of light emitting diodes 40 may be inserted into the connection film 50 while the connection film 50 melts. In the case where the connection film 50 is cured in a curing process, the plurality of light emitting diodes 40 may be firmly fixed to the first surface 30a of the substrate 30 physically.

According to one or more embodiments, the connection film 50 may include a plurality of conductive adhesive members 51 and a sheet 53.

According to one or more embodiments, the plurality of conductive adhesive members 51 may have a gap and a size so as to not cause a short circuit between the conductive adhesive members after thermal compression. The plurality of conductive adhesive members 51 may be arranged continuously at regular intervals. The plurality of conductive adhesive members 51 may respectively have a less size than the first substrate pad 31 and the second substrate pad 32 of the substrate 30, and the first electrode pad 41 and the second electrode pad 42 of the light emitting diode 40.

According to one or more embodiments, the conductive adhesive member 51 may be patterned on the sheet 53. For example, the plurality of conductive adhesive members 51 may be provided to the sheet 53 in a grid pattern as illustrated in FIG. 2. The conductive adhesive members 51-1, 51-2 adjacent to each other in a column (row) direction may be arranged at a first pitch P1. The conductive adhesive members 51-1, 51-3 adjacent to each other in a row (column) direction may be arranged at a second pitch P2. The first pitch P1 and the second pitch P2 may be identical, but not limited thereto.

According to one or more embodiments, the plurality of conductive adhesive members 51 may correspond to one substrate pad of the substrate 30 to secure a sufficient electrical connection between the substrate 30 and the light emitting diode 40. In this case, the first pitch P1 and the second pitch P2 may be set to be less than a pitch in the column (row) direction and a pitch in the row (column) direction of the plurality of substrate pads 31, 32 provided to the substrate 30.

According to one or more embodiments, the surface area of the conductive adhesive member 51 may be determined based on a minimum surface area S out of the surface areas of the first substrate pad 31 and the second substrate pad 32 of the substrate 30 and the surface areas of the first electrode pad 41 and the second electrode pad 42 of the light emitting diodes 40. For example, the surface area of the conductive adhesive member 51 may range from 30% to 80% of the minimum surface area S.

According to one or more embodiments, when viewed from a planar perspective, the conductive adhesive member 51 may have a square shape as illustrated in FIG. 2. However, the shape of the conductive adhesive member 51 may not be limited thereto, and the conductive adhesive member 51 may have various shapes such as a triangle, a circle, an oval, a star and the like.

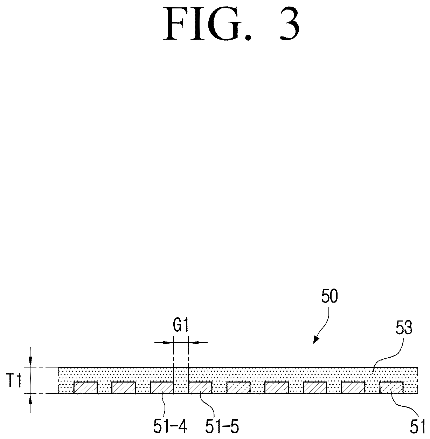

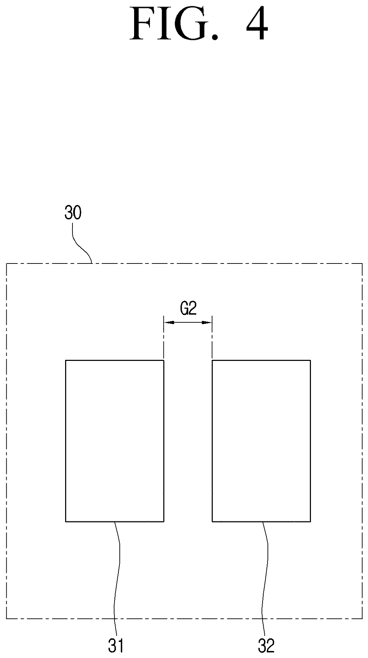

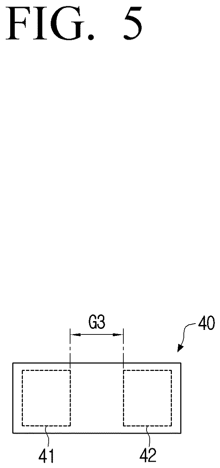

FIG. 3 is a cross-sectional view illustrating a connection film along A-A' in FIG. 2 according to one or more embodiments, which shows a gap G1 between adjacent conductive adhesive members. FIG. 4 is a view illustrating a substrate provided with a first substrate pad and a second substrate pad according to one or more embodiments, which shows a gap G2 between the first substrate pad and the second substrate pad. FIG. 5 is a view illustrating a light emitting diode provided with a first electrode pad and a second electrode pad according to one or more embodiments, which shows a gap G3 between the first electrode pad and the second electrode pad.

According to one or more embodiments, the first gap G1 (see FIG. 3) of conductive adhesive members 51 adjacent to each other may be determined with respect to a minimum gap G0 out of the second gap G2 (see FIG. 4) of the first substrate pad 31 and the second substrate pad 32 of the substrate 30 and a third gap G3 (see FIG. 5) of the first electrode pad 41 and the second electrode pad 42 of the light emitting diode 40. For example, the first gap G1 of the conductive adhesive members 51 adjacent to each other may range from 1% to 30% of the minimum gap G0.

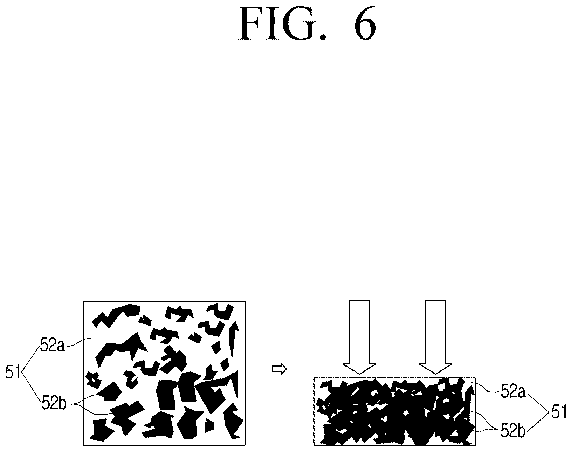

FIG. 6 is a view showing an example a conductive adhesive member of a connection film, which is deformed from a non-conductible state to a conductible state based on thermal compression according to one or more embodiments.

According to one or more embodiments, curing temperature of the conductive adhesive member 51 may be less than 200°C considering thermal resistance limitations. A resistance value R of the conductive adhesive member 51 may range from 0.1 ohm to 20 ohm after curing. In the case where the resistance value R is less than 0.1 ohm after curing of the conductive adhesive member 51, the dispersibility of a material may not be satisfied, and in the case where the resistance value R is greater than 20 ohm after curing of the conductive adhesive member 51, loss of current may occur, making it hard to use the material as the conductive adhesive member 51.

According to one or more embodiments, the conductive adhesive member 51, as illustrated in FIG. 6, may include epoxy resin 52a, and conductive materials 52b dispersed in the epoxy resin 52a. The epoxy resin 52a may physically connect the first substrate pad 31 and the second substrate pad 32 of the substrate 30 with the first electrode pad 41 and the second electrode pad 42 of the light emitting diode 40 one another, based on thermal compression and a curing process. The conductive materials 52b may be materials of high conductivity. For example, the conductive materials 52b may be gold (Au), silver (Ag), carbon (C), copper (Cu), nickel (Ni), aluminum (Al), indium (In), or tin (Sn). The conductive materials 52b, as illustrated in FIG. 6, may be disposed in a dispersed manner such that most of the conductive materials 52b are spaced from one another in the epoxy resin 52a, without contacting one another. The conductive adhesive member 51 compressed at a time of thermal compression may go into a conductible state. In this case, the gap of the conductive materials 52b of the conductive adhesive member 51 compressed may become narrow, such that the conductive materials 52b contact one another or clump together and become conductible.

According to one or more embodiments, the sheet 53 may be comprised of an insulation material. The sheet 53, for example, may be a thermoplastic material (styrene butadiene, or polyvinyl butylene) or a thermoset material (epoxy resin, polyurethane, or acrylic resin).

According to one or more embodiments, the sheet 53 may be formed of a pigment or dye having a black-shade color of high optical density and low reflectivity to secure a visual sensation of black. For example, the sheet 53 may improve cross talk among adjacent light emitting diodes 40 by absorbing light emitted from the plurality of light emitting diodes 40 provided to the substrate 30, and may improve a contrast ratio by absorbing external light. The sheet 53, for example, may be formed of a material having reflectivity less than or equal to about 9% in the entire wavelength area (e.g., 390 nm-700 nm) of visible light.

According to one or more embodiments, the sheet 53 may be formed of a material having an optical property L (Luminosity) ranging from 0.1 to 30. In the case where a material forming the sheet 53 has an optical property less than 0.1, curing may not be smoothly performed, causing difficulty in manufacturing. In the case where the optical property L of a material forming the sheet 53 exceeds 30, the quality of black may deteriorate.

According to one or more embodiments, the sheet 53 may be formed of a material having an adhesive force. The adhesive force T of a material forming the sheet 53 may range from 0.1 g (gram) to 1 g (gram). In the case where a material forming the sheet 53 has an adhesive force less than 0.1 g, the light emitting diode 40 may hardly be fixed to the substrate 30 physically due to a weak adhesive force. In the case where a material forming the sheet 53 has an adhesive force greater than 1 g, the light emitting diodes 40 may hardly be repaired due to a strong adhesive force. For example, for the light emitting diode 40 to be repaired, the connection film 50 cured by applying heat to the substrate 30 may be deformed to have flexibility such that a defective light emitting diode mounted on the substrate 30 may separate from the substrate 30.

According to one or more embodiments, the sheet 53 may be formed of a material having both the above-described optical property L range (0.1-30) and the above-described adhesive force T range (0.1 g-1 g).

According to one or more embodiments, the sheet 53 may be thick enough for the first electrode pad 41 and the second electrode pad 42 of the light emitting diode 40 respectively to be connected to the first substrate pad 31 and the second substrate pad 32 of the substrate 30 electrically, at a time when the light emitting diode 40 transferred to the substrate 30 is thermally compressed. For example, the sheet 53 may have a thickness less than or equal to 35 µm.

According to one or more embodiments, the sheet 53 may be formed to surround the lateral surface of the lower portion of the plurality of light emitting diodes 40. Since the sheet 53 has a black-shade color, the sheet 53 may absorb light emitted from the light emitting diodes 40 to minimize or improve cross talk of adjacent light emitting diodes 40. In this case, the sheet 53 may function as a black matrix.

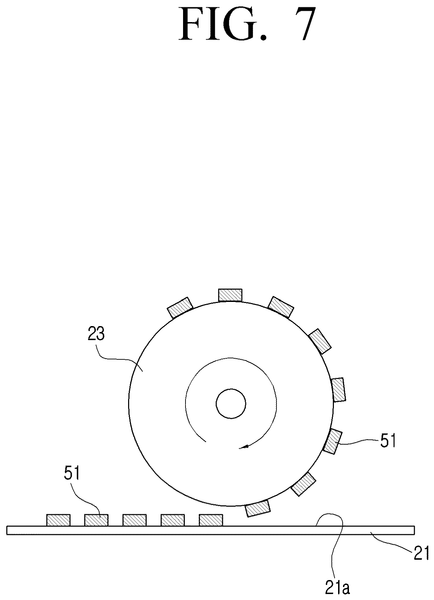

Hereafter, a manufacturing process of the connection film 50 according to one or more embodiments is described. FIGS. 7-10 are views illustrating a manufacturing process of a connection film 50 according to one or more embodiments.

Referring to FIG. 7, the plurality of conductive adhesive members 51 may be printed on a support plate 21 based on an imprint method. The plurality of conductive adhesive members 51 may be provided to an imprinting stamp 23 in a pre-determined pattern (e.g., a grid pattern). The imprinting stamp 23 may print the plurality of conductive adhesive members 51 on an upper surface 21a of the support plate 21 in a grid pattern, while rotating in one direction. Based on the imprint method, the connection film 50 including the plurality of conductive adhesive members 51 of a micro size may be manufactured to have a large surface area.

The plurality of conductive adhesive members 51 may be formed on the support plate 21 in a grid pattern based on a slit coating method by which the support plate 21 is coated with a pigment by using a slit nozzle, an inkjet printing method or a 3D printing method using a three dimension printer as well as the imprint method.

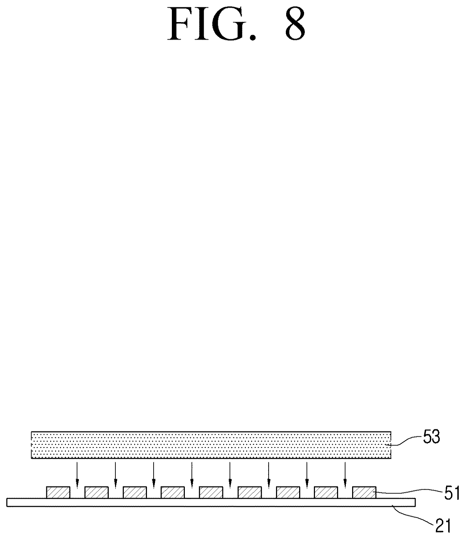

Referring to FIG. 8, the plurality of conductive adhesive members 51 may have pre-determined hardness since the plurality of conductive adhesive members 51 is patterned on the support plate 21 and then cured. Then the sheet 53 having a black-shade color is laminated on the upper surface 21a of the support plate 21. In this case, the sheet 53 may have flowability because of heat provided to the sheet 53 at a time of laminating the sheet 53 on the upper surface 21a of the support plate 21. The sheet 53 may cover the plurality of conductive adhesive members 51. Part of the sheet 53 may flow in between the plurality of conductive adhesive members 51 cured.

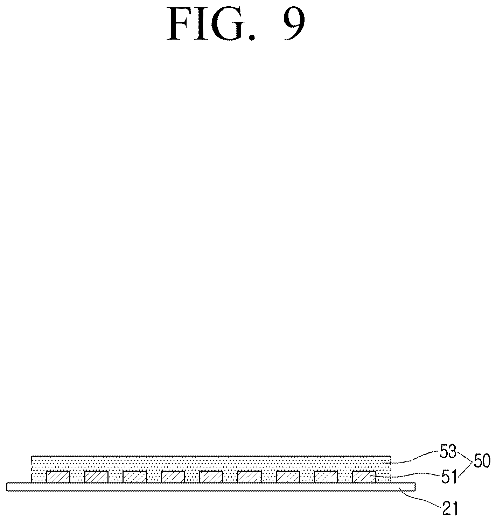

Referring to FIG. 9, the plurality of conductive adhesive members 51 may be coupled with the sheet 53 in the state where the plurality of conductive adhesive members 51 maintains a grid pattern on the sheet 53. The plurality of conductive adhesive members 51 and the sheet 53 may be integrally formed based on curing, and may constitute the connection film 50.

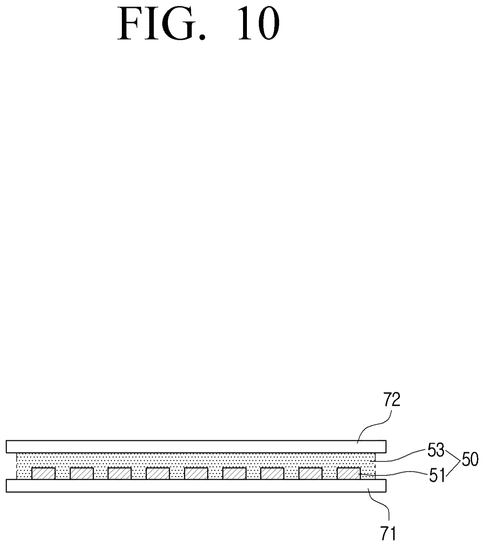

Referring to FIG. 10, after the connection film 50 separates from the support plate 21, a first protective sheet 71 and a second protective sheet 72 may be attached onto both the surfaces of the connection film 50 to protect the connection film 50. The connection film 50 may be stored and transported in the state where the first protective sheet 71 and the second protective sheet 72 are attached to the connection film 50.

Hereafter, an example of an electrical and physical connection of the plurality of light emitting diodes 40 to the substrate 30 by using the connection film 50 is described with reference to the drawings.

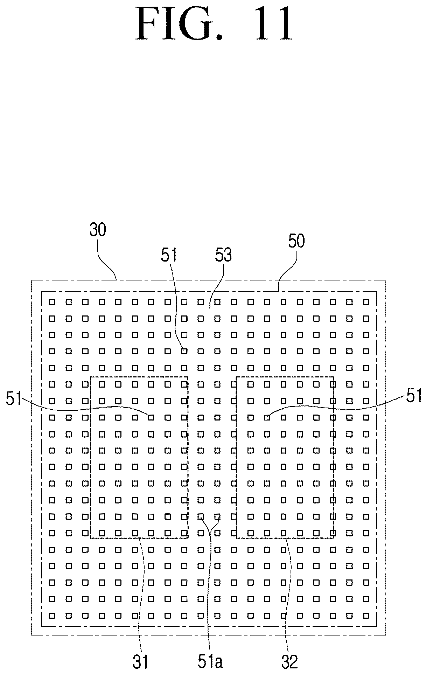

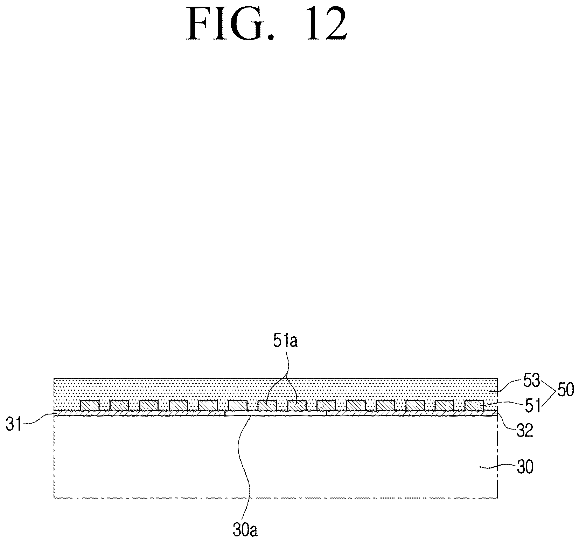

FIG. 11 is a plan view showing an example of an attachment of a connection film onto a substrate according to one or more embodiments. FIG. 12 is a cross-sectional view showing an example of an attachment of a connection film onto a substrate according to one or more embodiments.

Referring to FIGS. 11 and 12, the connection film 50 may be laminated on the first surface 30a of the substrate 30 in a direction where the plurality of conductive adhesive members 51 faces the first substrate pad 31 and the second substrate pad 32 of the substrate 30 before the plurality of light emitting diodes 40 is transferred to the substrate 30. In this case, the plurality of conductive adhesive members 51 may correspond respectively to the first substrate pad 31 and the second substrate pad 32 of the substrate 30 as illustrated in FIG. 11. The plurality of conductive adhesive members 51 corresponding to the first substrate pad 31 and the second substrate pad 32 of the substrate 30 may contact the first substrate pad 31 and the second substrate pad 32 of the substrate 30 as illustrated in FIG. 12.

The plurality of conductive adhesive members 51 is disposed at a constant first-gap G1 interval. Accordingly, a short circuit may not occur with the help of a plurality of conductive adhesive members 51a corresponding between the first substrate pad 31 and the second substrate pad 32 of the substrate 30.

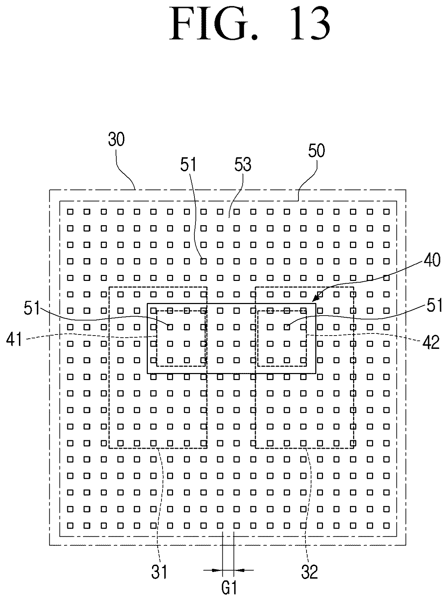

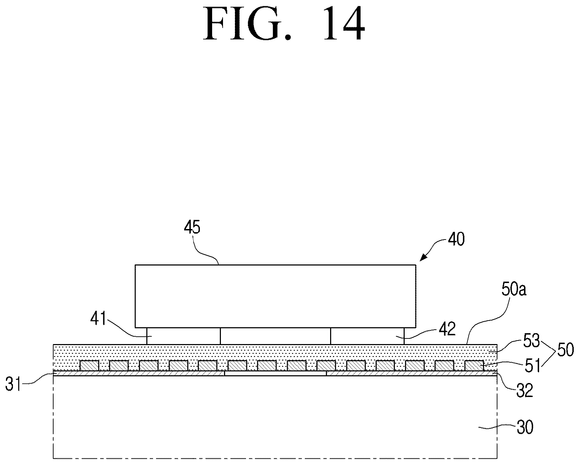

FIG. 13 is a plan view showing an example of a transfer of a light emitting diode onto a connection film according to one or more embodiments. FIG. 14 is a cross-sectional view illustrating a light emitting diode transferred onto a connection film according to one or more embodiments.

Referring to FIG. 13, before the plurality of light emitting diodes 40 is transferred to the substrate 30, the first electrode pad 41 and the second electrode pad 42 of each light emitting diode 40 are aligned on the first substrate pad 31 and the second substrate pad 32 of the substrate 30, which respectively correspond to the first electrode pad 41 and the second electrode pad 42.

As the alignment is completed, the plurality of light emitting diodes 40 is transferred to the substrate 30 on which the connection film 50 is laminated. In this case, as illustrated in FIG. 14, the first electrode pad 41 and the second electrode pad 42 of the light emitting diode 40, which are mounted on an upper surface 50a of the connection film 50, may be disposed to correspond respectively to the first substrate pad 31 and the second substrate pad 32 of the substrate 30. Herein, the upper surface 50a of the connection film 50 is a surface the same as the upper surface of the sheet 53.

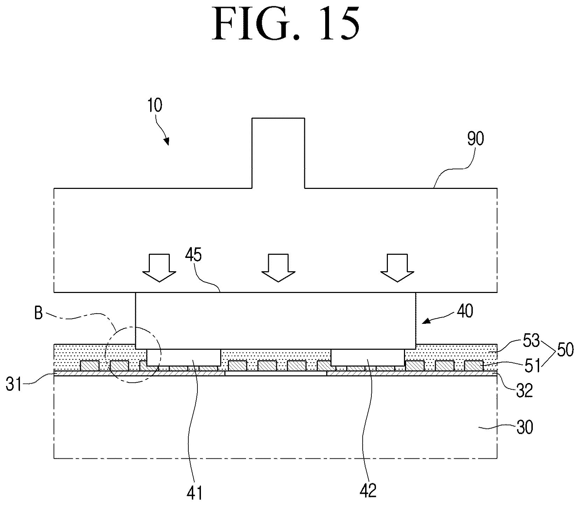

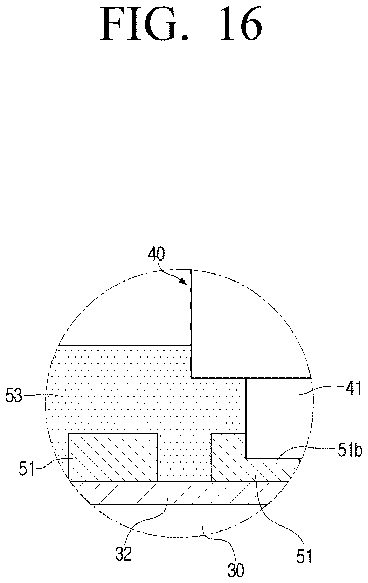

FIG. 15 is a cross-sectional view illustrating a display panel according to one or more embodiments, which shows an example of thermal compression of a light emitting diode toward a substrate. FIG. 16 is an enlarged view illustrating portion B in FIG. 15.

Referring to FIG. 15, the plurality of light emitting diodes 40 transferred to the substrate 30 may be thermally compressed toward the substrate 30 by using a pressurization device 90. In this case, the temperature of heat released from the pressurization device 90 may be 60-150 °C, and pressure may be less than or equal to 10 Mpa.

The pressurization device 90 may have a surface area approximately corresponding to that of the substrate 30, and have a heater including a heat generation coil therein. The pressurization device 90 may release high-temperature heat while pressurizing a light emitting surface 45 of the light emitting diode 40 at pre-determined pressure.

The sheet 53 of the connection film 50 may have flowability because of the heat released from the pressurization device 90. Accordingly, the light emitting diode 40 may be inserted into the sheet 53 of the connection film 50 having flowability, while being pressed toward the substrate 30 by the pressurization device 90.

The first electrode pad 41 and the second electrode pad 42 of the light emitting diode 40 may contact the plurality of conductive adhesive members 51 of the connection film 50, which correspond to the first electrode pad 41 and the second electrode pad 42. In this case, the first electrode pad 41 and the second electrode pad 42 of the light emitting diode 40 may be electrically connected with the first substrate pad 31 and the second substrate pad 32 of the substrate 30, which correspond to the first electrode pad 41 and the second electrode pad 42, through the plurality of conductive adhesive members 51 of the connection film 50.

Referring to FIG. 16, in the case where the light emitting diode 40 is thermally compressed toward the substrate 30 by using the pressurization device 90, all or a portion 51b of the conductive adhesive member 51 of the connection film 50 may be pressurized by the first electrode pad 41 of the light emitting diode 40. In this case, the conductive materials 52b dispersed in the conductive adhesive member 51 pressurized may contact one another or clump together such that the conductive adhesive member 51 may go into a conductible state. Further, the other portion of the conductive adhesive member 51 not pressurized by the first electrode pad 41 of the light emitting diode 40 may mostly maintain its shape.

In the case where the connection film 50 is cured after thermal compression, the light emitting diode 40 may be physically fixed to the substrate 30 firmly while the sheet 53 of the connection film 50, which has flowability, shrinks.

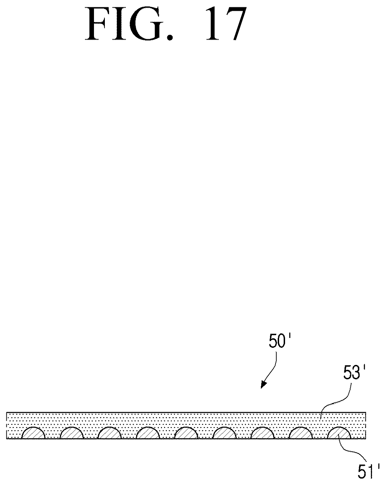

FIG. 17 is a cross-sectional view illustrating a connection film according to one or more embodiments.

Referring to FIG. 17, a connection film 50' according to one or more embodiments may include a plurality of conductive adhesive members 51' and a sheet 53' in which the plurality of conductive adhesive members 51' is patterned. The conductive adhesive member 51' and the sheet 53' have the same properties as the above-described conductive adhesive members 51 and sheet 53. Accordingly, detailed description in relation to these is avoided.

The plurality of conductive adhesive members 51' illustrated in FIG. 17 may have an approximate arc cross section that is different from a square cross section of the plurality of conductive adhesive members 51 illustrated in FIG. 3. In this case, the conductive adhesive members 51' may have a dome shape in three dimensions.

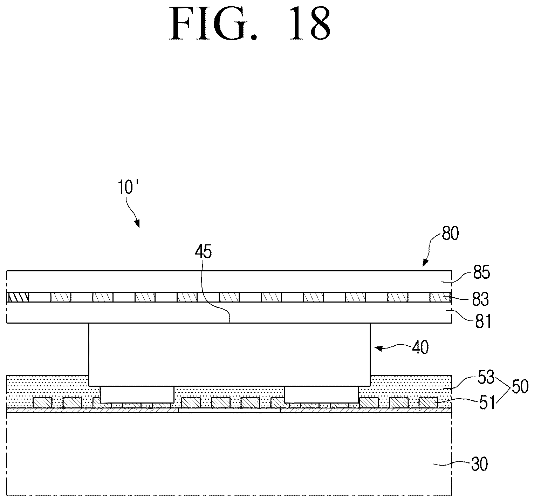

FIG. 18 is a view showing an example of a provision of a touch screen to a display panel according to one or more embodiments.

Referring to FIG. 18, a display panel 10' according to one or more embodiments may further include a touch screen 80 disposed at the upper side of the plurality of light emitting diodes 40. Accordingly, the display panel 10' may provide various functions such as a function of inputting various instructions through a UI/UX displayed on the display panel 10' through the touch screen 80, or a function of enlarging or shrinking an image displayed on the display panel 10', and the like.

According to one or more embodiments, the touch screen 80 may include a protective film 81 mounted on the light emitting surface 45 of the light emitting diode 40, an optical film 83 disposed on the protective film 81, and a transparent electrode ITO 85 disposed between the protective film 81 and the optical film 83. The transparent electrode 85 may be a capacitive touch wirings.

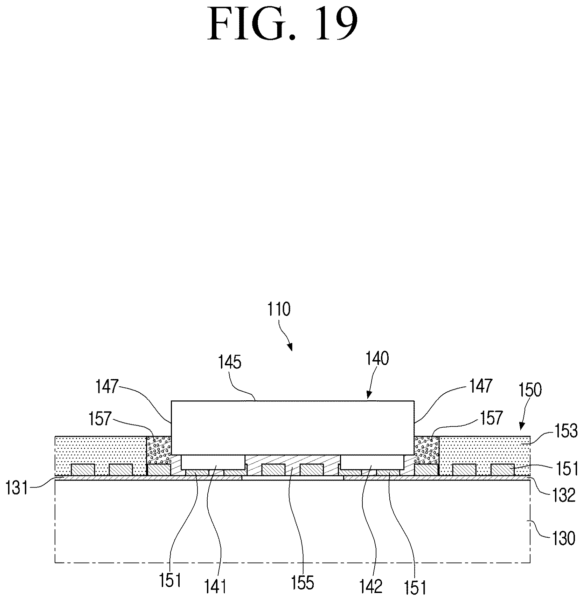

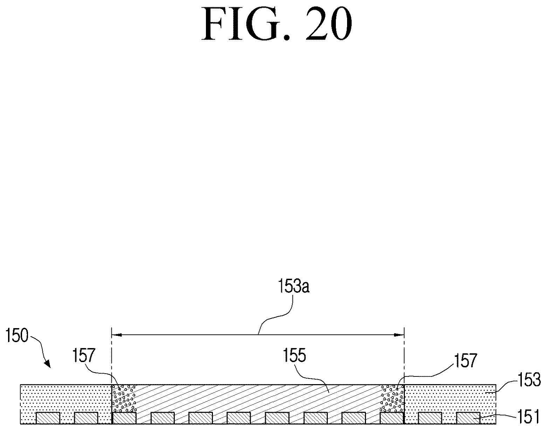

FIG. 19 is a cross-sectional view illustrating a display panel according to one or more embodiments. FIG. 20 is a cross-sectional view illustrating a connection film according to one or more embodiments.

Referring to FIG. 19, a display panel 110 may include a substrate 130, a connection film 150 provided to the substrate 130, and a plurality of light emitting diodes 140 connected to the substrate 130 electrically and physically by the connection film 150. The configuration of each of the substrate 130 and the light emitting diode 140 is substantially the same as that of each of the above-described substrate 30 and light emitting diode 40. Accordingly, detailed description of the substrate 130 and the light emitting diode 140 is avoided.

According to one or more embodiments, the plurality of light emitting diodes 140 may be connected electrically and physically to the substrate 130 by the connection film 150. The lower portion of the light emitting diode 140 including a first electrode pad 141 and a second electrode pad 142 may be inserted into an insulation resin 155 of the connection film 150, which has a gray-shade color. The first electrode pad 141 and the second electrode pad 142 of the light emitting diode 140 may be electrically connected to a first substrate pad 131 and a second substrate pad 132 of the substrate 130, which correspond to the first electrode pad 141 and the second electrode pad 142, by a plurality of conductive adhesive members 151 of the connection film 150. The light emitting diode 140 may be physically fixed to the substrate 130 by the sheet 153 of the connection film 150 firmly.

According to one or more embodiments, a lateral surface 147 of the light emitting diode 140 may be surrounded by a reflective member 157 of the connection film 150, part of which is inserted into the insulation resin 155. The reflective member 157 may improve light emission efficiency of the light emitting diode 140 by reflecting light emitted from the lateral surface 147 of the light emitting diode 140 toward the light emitting surface 145 of the light emitting diode 140, and improve cross talk by minimizing an amount of light emitted toward an adjacent light emitting diode 140.

Referring to FIG. 20, the connection film 150 according to one or more embodiments may include a plurality of conductive adhesive members 151, a sheet 153 having a black-shade color, an insulation resin 155 having a gray-shade color, and a reflective member 157 disposed along the edge of the insulation resin 155.

The plurality of conductive adhesive members 151 may be provided to the sheet 153 in a grid pattern. The plurality of conductive adhesive members 151 has the same property as the above-described conductive adhesive members 51. Accordingly, description of the conductive adhesive members 151 is avoided.

According to one or more embodiments, the sheet 153 of the connection film 150 may have the same property as the sheet 53 of the above-described connection film 50. The sheet 153 may have a plurality of openings 153a. The plurality of openings 153a provided to the sheet 153 may be filled with the insulation resin 155. The insulation resin 155 may have a luminance property of 1 < RGB < 100 to secure improvement in reflection efficiency. Such a luminance property of 1 < RGB < 100 may be a brightness range that is obtainable in the case where red has a range of 1-100, green has a range of 1-100, and blue has a range of 1-100 in an RGB mode, and red, green and blue are respectively selected as a color corresponding to one value out of 1-100, and the selected three colors are mixed.

The reflective member 157 may be disposed along the edge of the insulation resin 155. In the case where the light emitting diode 140 is thermally compressed to the substrate 130, the reflective member 157 may be disposed at a position where the reflective member 157 is prevented from fitting between the first substrate pad 131 and the second substrate pad 132 of the substrate 130, and the first electrode pad 141 and the second electrode pad 142 of the light emitting diode 140, which correspond to the first substrate pad 131 and the second substrate pad 132. For example, in the case where the reflective member 157 fits between the first substrate pad 131 and the second substrate pad 132 of the substrate 130, and the first electrode pad 141 and the second electrode pad 142 of the light emitting diode 140, which correspond to the first substrate pad 131 and the second substrate pad 132, an electrical connection between the substrate pads of the substrate 130 and the electrode pads of the light emitting diode 140 may not be performed smoothly.

The reflective member 157 may be considered to surround the lateral surface 147 of the light emitting diode 140. The reflective member 157 may include a plurality of glass balls. The size of the reflective member 157 may be less than the size of the conductive adhesive member 151. For example, the size of the glass balls may be less than or equal to about 10% of the size of the conductive adhesive member 151.

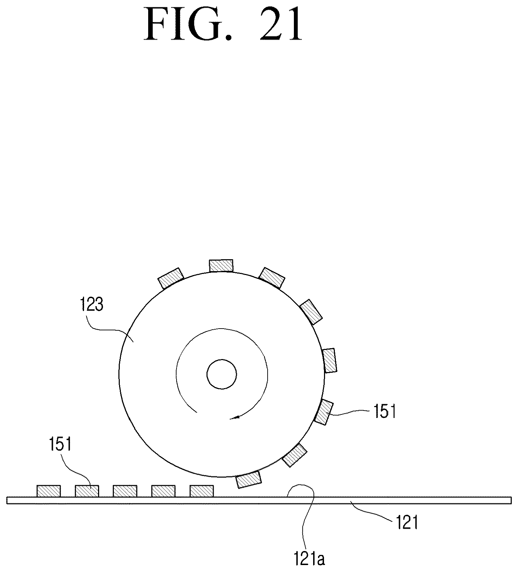

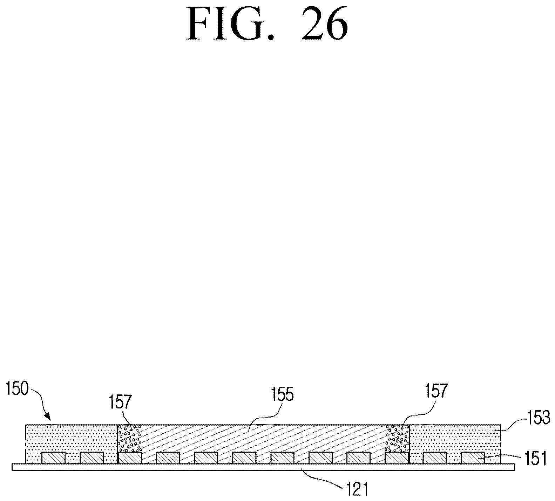

FIGS. 21 to 26 are views showing a manufacturing process of a connection film according to one or more embodiments.

Referring to FIG. 21, the plurality of conductive adhesive members 151 may be printed on a support plate 121 based on an imprint method. The plurality of conductive adhesive members 151 may be provided to an imprinting stamp 123 in a pre-determined pattern (e.g., a grid pattern). The imprinting stamp 123 may print the plurality of conductive adhesive members 151 in a grid pattern, on an upper surface 121a of the support plate 121, while rotating in one direction. Based on the imprint method, the connection film 150 including the plurality of conductive adhesive members 151 of a micro size may be manufactured to have a large surface area. The plurality of conductive adhesive members 151 may be formed on the support **plate 121** in a grid pattern based on a slit coating method, an inkjet printing method or a 3D printing method as well as the imprint method.

The plurality of conductive adhesive members 151 printed on the support plate 121 may be cured to have defined hardness through a curing process.

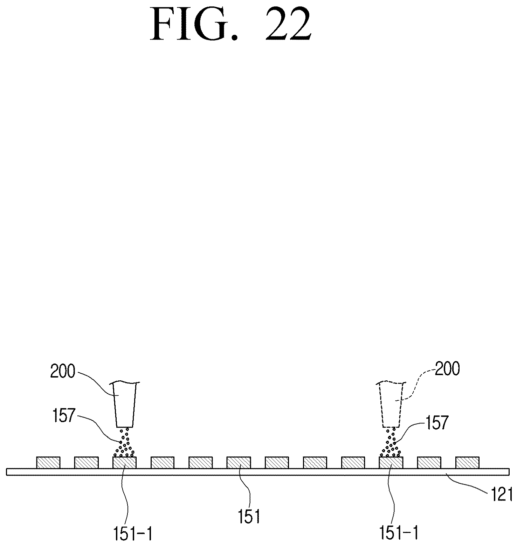

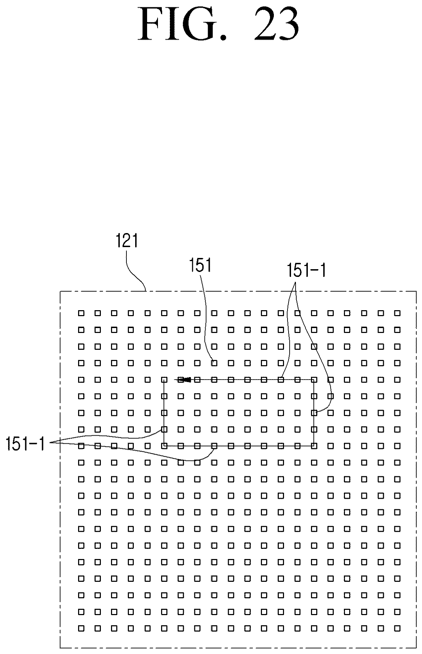

Referring to FIG. 22, the reflective member 157 is discharged to part 151-1 of the plurality of conductive adhesive members 151 from a first dispenser 200. For example, a moving path of the first dispenser 200, as illustrated in FIG. 23, may be a trajectory corresponding to the outer edge of the light emitting diode 140. The first dispenser 200 may discharge the reflective member 157 to the upper surfaces of the conductive adhesive members 151-1 corresponding to the trajectory, and to a space between the conductive adhesive members 151-1 corresponding to the trajectory, while moving along the trajectory. In this case, the reflective member 157 may have an approximate rectangle strap shape approximately corresponding to the shape of the outer edge of the light emitting diode 140. The reflective member 157 may be discharged from the first dispenser 200 in the state where the reflective member 157 is mixed with a pigment having viscosity. Accordingly, the reflective member 157 discharged from the first dispenser 200 may be formed into a dam maintaining a pre-determined height. Herein, the pigment mixed with the reflective member 157 may be a transparent resin or a resin the same as the insulation resin 155.

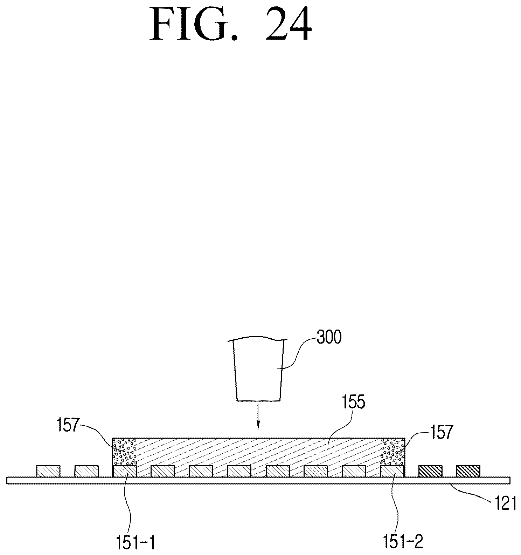

Referring to FIG. 24, the reflective member 157 and the insulation resin 155 in the inner space of the reflective member 157, having a rectangle shape, may be discharged to the support plate 121 from a second dispenser 300. The insulation resin 155 may be a resin having a gray-shade color of a luminance property (1 < RGB < 100) to secure improvement in reflection efficiency of light emitted from the light emitting diode 140.

The insulation resin 155 may be discharged in a grid pattern to the support plate 121 with a constant pitch. The pitch of a plurality of insulation resins 155 may correspond to the pitch of the plurality of light emitting diodes 140 transferred to the substrate 130 in a grid arrangement.

The plurality of insulation resins 155 may be cured through a curing process after being discharged to the support plate 121.

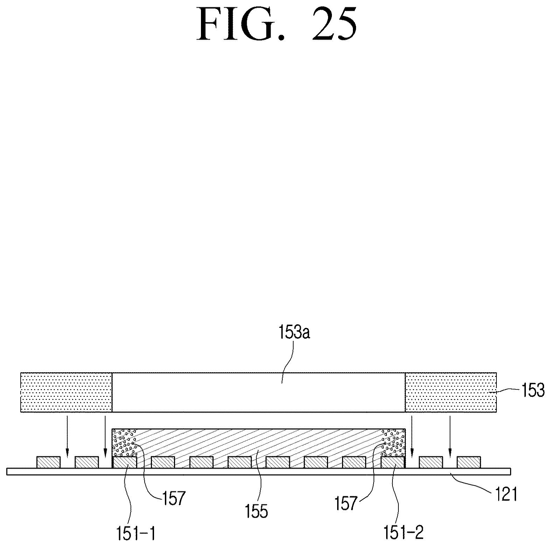

Referring to FIG. 25, the sheet 153 may be provided with a plurality of openings 153a corresponding to the plurality of insulation resins 155. The plurality of openings 153a of the sheet 153 is aligned with the plurality of insulation resins 155 on the support plate 121, and then the sheet 153 may be attached to the support plate 121. The plurality of insulation resins 155 having a gray-shade color may be inserted into the plurality of openings 153a of the sheet 153 having a black-shade color and integrally formed with the sheet 153. In this case, the shape of the plurality of openings 153a may be substantially the same as the shape of the plurality of insulation resins 155.

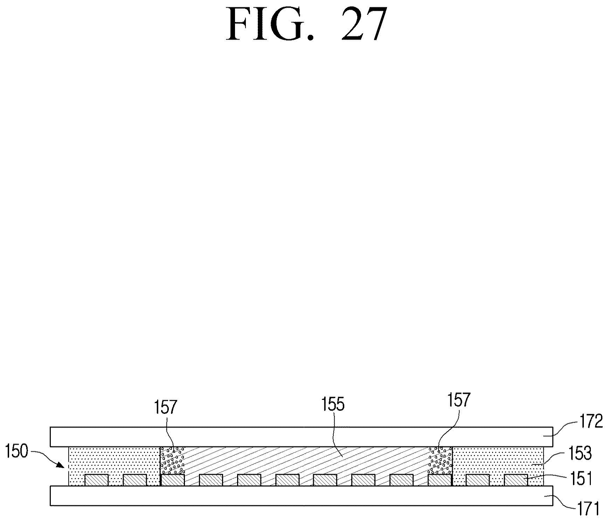

Referring to FIG. 27, after the connection film 150 separates from the support plate 121, a third protective sheet 171 and a fourth protective sheet 172 may be attached to both the surfaces of the connection film 150 to protect the connection film 50. The connection film 150 may be stored and transported in the state where the third protective sheet 171 and the fourth protective sheet 172 are attached to the connection film 150.

Hereafter, an example of an electrical and physical connection of the plurality of light emitting diodes 140 to the substrate 130 by using the connection film 50 is described with reference to the drawings.

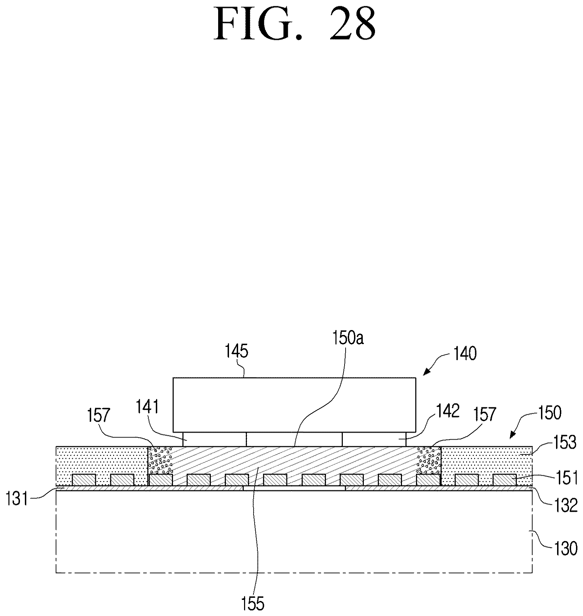

FIG. 28 is a cross-sectional view illustrating a light emitting diode transferred onto a connection film according to one or more embodiments.

Referring to FIG. 28, before the plurality of light emitting diodes 140 is transferred to the substrate 130, the first electrode pad 141 and the second electrode pad 142 of each light emitting diode 140 are aligned on the first substrate pad 131 and the second substrate pad 132 of the substrate 130, which respectively correspond to the first electrode pad 141 and the second electrode pad 142. When respectively viewed from a planar perspective, the plurality of light emitting diodes 140 may be aligned to be disposed inside the reflective member 157 having a rectangle strap shape.

As the alignment is completed, the plurality of light emitting diodes 140 is transferred to the substrate 130 on which the connection film 150 is laminated. In this case, the first electrode pad 141 and the second electrode pad 142 of the light emitting diode 140, which are mounted on an upper surface 150a of the connection film 150, may be disposed to correspond respectively to the first substrate pad 131 and the second substrate pad 132 of the substrate 130. Herein, the upper surface 150a of the connection film 150 is a surface the same as the upper surface of the insulation resin 153.

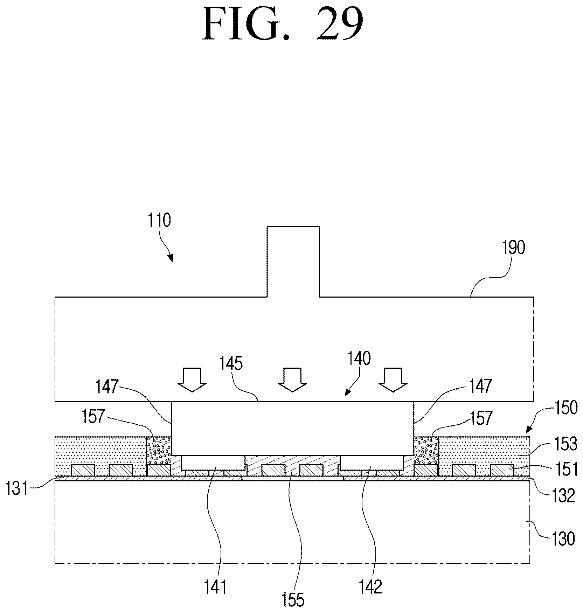

FIG. 29 is a cross-sectional view illustrating a display panel according to one or more embodiments.

Referring to FIG. 29, the plurality of light emitting diodes 140 transferred to the substrate 130 may be thermally compressed toward the substrate 130 by using a pressurization device 190. In this case, the temperature of heat released from the pressurization device 190 may be 60-150 °C, and pressure may be less than or equal to 10 Mpa.

The insulation resin 155 of the connection film 150 may have flowability because of the heat released from the pressurization device 190. Accordingly, the light emitting diode 140 may be inserted into the insulation resin 155 of the connection film 150 having flowability, while being pressed toward the substrate 130 by the pressurization device 190.

The first electrode pad 141 and the second electrode pad 142 of the light emitting diode 140 may contact the plurality of conductive adhesive members 151 of the connection film 150, which correspond to the first electrode pad 141 and the second electrode pad 142. In this case, the first electrode pad 141 and the second electrode pad 142 of the light emitting diode 140 may be electrically connected with the first substrate pad 131 and the second substrate pad 132 of the substrate 130, which correspond to the first electrode pad 141 and the second electrode pad 142, through the plurality of conductive adhesive members 151 of the connection film 150.

In this case, the lateral surface 147 of the light emitting diode 140 may be surrounded by the reflective member 157 of the connection film 150 in the state where the lateral surface 147 of the light emitting diode 140 contacts or is adjacent to the reflective member 157 of the connection film 150. Accordingly, light emitted from the lateral surface 147 of the light emitting diode 140 may be reflected from the reflective member 157 of the connection film 150 and emitted through the light emitting surface 145 of the light emitting diode 140.

Additionally, the lower portion of the light emitting diode 140 may be inserted into the insulation resin 155 of the connection film 150, which has a gray-shade color. The insulation resin 155 may enhance a light reflection rate compared to the sheet 153 having a black-shade color.

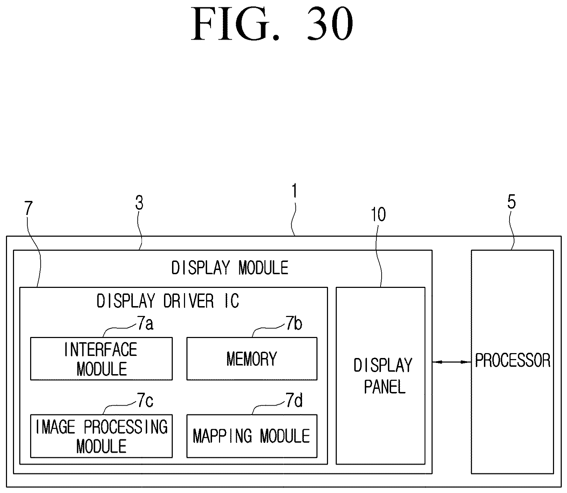

FIG. 30 is a block diagram illustrating a display device according to one or more embodiments.

Referring to FIG. 30, a display device 1 may include a display module 3 and a processor 5. The display module 3 may include a display panel 10 and a display driver integrated circuit (a display driver IC) 7 for controlling the display panel 10.

The processor 5 may include a digital signal processor (DSP) processing digital image signals, a microprocessor, a graphics processing unit (GPU), an artificial intelligence (AI) processor, a neural processing unit (NPU), a time controller (TCON), but not be limited thereto, and the processor 5 may include one or more of a central processing unit (CPU), a micro controller unit (MCU), a micro processing unit (MPU), a controller, an application processor (AP), or a communication processor (CP), an ARM processor, or may be defined as such terms. Additionally, the processor 5 may be implemented in the form of a system on a chip (SoC) with embedded processing algorithms, a large scale integration (LSI), or in the form of an application specific integrated circuit (ASIC), a field programmable gate array (FPGA).

The processor 5 may control hardware or software elements connected thereto by driving an operating system or an application program, and perform processing and computing of various types of data. Additionally, the processor 5 may load instructions or data received from at least one of other elements to volatile memory and process the same, and may store various types of data in the volatile memory.

The display driver IC 7 may include an interface module 7a, memory 7b (e.g., buffer memory), an image processing module 7c or a mapping module 7d. The display driver IC 7, for example, may receive, from another element of the display device 1, image data or image information including an image control signal corresponding to an instruction for controlling the image data, through the interface module 7a. For example, according to one embodiment, the image information may be received from the processor 5 (e.g., a main processor (e.g., an application processor) or a co-processor (e.g., a graphics processing unit) operating independently from the functions of the main processor.

The display driver IC 7 may communicate through a sensor module and the interface nodule 7a. Additionally, the display driver IC 7 may store at least part of the received image information to the memory 7b, for example, based on a frame unit. The image processing module 7c, for example, may perform pre-processing or post-processing (e.g., an adjustment of resolution, brightness or a size) of at least part of the image data, at least based on the property of the image data or the property of the display panel 10. The mapping module 7d may generate a voltage value or a current value corresponding to the image data pre-processed or post-processed through the image processing module 7c. According to one embodiment, the voltage value or current value, for example, may be generated at least partially based on the properties of pixels of the display panel 10 (e.g., an arrangement of pixels (an RGB stripe or pentile structure), or the size of each sub pixel). At least part of the pixels of the display panel 10, for example, may be driven at least partially based on the voltage value or current value, such that visual information (e.g., a text, an image, or an icon) corresponding to the image data may be displayed through the display panel 10.

The display driver IC 7 may transmit a driving signal (e.g., a driver driving signal, a gate driving signal and the like) to the display, based on the image information received from the processor 5.

The display driver IC 7 may display an image based on the image signal received from the processor 5. As one example, the display driver IC 7 may generate driving signals of a plurality of sub pixels based on the image signal received from the processor 5, and based on the driving signals, may control light emission of the plurality of sub pixels to display an image.

According to one or more embodiments, the display module 3 may further include touch circuitry. The touch circuitry may include a touch sensor and a touch sensor IC for controlling the touch sensor. The touch sensor IC, for example, may control the touch sensor to sense a touch input or a hovering input to a designated position of the display panel 10. For example, the touch sensor IC may sense a touch input or a hovering input by measuring a change in a signal (e.g., a voltage, a light amount, resistance or a charge amount) of the designated position of the display panel 10. The touch sensor IC may provide information (e.g., a position, a surface area, pressure, or time) on the sensed touch input or hovering input to the processor 5. According to one embodiment, at least part (e.g., a touch sensor IC) of the touch circuitry may be included as part of the display driver IC 7 or the display panel 10, or part of another element (e.g., a co-processor) disposed outside the display module 3.

According to one or more embodiments, a pixel driving method of the display module 3 may be an active matrix (AM) driving method or a passive matrix (PM) driving method.

According to one or more embodiments, the display device 1 may include a display module 3. The display module 3 may display various types of images. Herein, the images may include still images and/or moving images. The display module 3 may display various types of images such as broadcasting contents, multimedia contents and the like. Additionally, the display module 3 may also display a user interface and an icon.

According to one or more embodiments, the display module 3 may be installed and applied in a wearable device, a portable device and a hand-held device, and various types of electronic products or electronic devices requiring a display.

According to one or more embodiments, the display device 1 may include a plurality of display modules 3. The plurality of display modules 3 may be connected physically and implement a large-scale display (e.g., a large format display). The large-scale display may be a monitor for a PC, a high-resolution television, a signage (or a digital signage) or an electronic display in which a plurality of display modules is connected in a grid arrangement.

While the embodiments of the present disclosure are illustrated and described above, those skilled in the art may understand that modifications are made in the shapes and particulars of the embodiments without departing from the technical spirit and scope of the disclosure defined by the claims attached hereafter and equivalents thereof.

## Claims

1. A connection film configured to connect a substrate and a plurality of light emitting diodes, the connection film comprising:
a sheet having a black-shade color; and
a plurality of conductive adhesive members provided at intervals on the sheet.

2. The connection film as claimed in claim 1, wherein the plurality of conductive adhesive members are provided in a grid pattern on the sheet.

3. The connection film as claimed in claim 1 or 2, wherein a surface area of each of the plurality of conductive adhesive members is less than a surface area of a substrate pad on the substrate and less than a surface area of an electrode pad on one of the plurality of light emitting diodes.

4. The connection film as claimed in claim 3, wherein the surface area of each of the plurality of conductive adhesive members is in a range of 30% to 80% of a minimum area among the surface area of the substrate pad and the surface area of the electrode pad.

5. The connection film as claimed in claim 3, wherein each of the plurality of conductive adhesive members has a curing temperature that is less than 200°C, and has a resistance value, after curing, in a range of 0.1 ohms to 20 ohms.

6. The connection film as claimed in claim 3, wherein each of the plurality of conductive adhesive members comprises:
epoxy resin; and
conductive materials in the epoxy resin, and
wherein the conductive materials are gold (Au), silver (Ag), carbon (C), copper (Cu), nickel (Ni), aluminum (Al), indium (In), or tin (Sn).

7. The connection film as claimed in claim 3, wherein the sheet has a luminosity in a range of 0.1 to 30.

8. The connection film as claimed in claim 1 or 2, wherein the sheet further comprises a plurality of openings, and
wherein the connection film further comprises:
an insulation resin having a gray-shade color and provided in the plurality of openings; and
a reflective member along an edge of the insulation resin and having a size that is less than a size of one of the plurality of conductive adhesive members.

9. The connection film as claimed in claim 8, wherein the reflective member comprises a plurality of glass balls.

10. The connection film as claimed in claim 8, wherein the insulation resin has a luminance property in which a brightness of each of red, green, and blue (RGB) is in a range of 1 < RGB < 100.

11. A display panel comprising:
a substrate;
a connection film attached to the substrate; and
a light emitting diode connected to the substrate by the connection film,
wherein the connection film comprises:
a sheet having a black-shade color; and
a plurality of conductive adhesive members provided at intervals on the sheet, and electrically connecting a plurality of substrate pads of the substrate with a plurality of electrode pads of the light emitting diode, and
wherein a gap between adjacent conductive adhesive members is in a range of 1% to 30% of a minimum gap among a gap between adjacent substrate pads and a gap between adjacent electrode pads.

12. The display panel as claimed in claim 11, wherein the plurality of conductive adhesive members is provided in a grid pattern on the sheet, and
wherein a surface area of each of the plurality of conductive adhesive members is in a range of 30% to 80% of a minimum surface area among a surface area of one of the plurality of substrate pads and a surface area of one of the plurality of electrode pads.

13. The display panel as claimed in claim 11, wherein each of the plurality of conductive adhesive members comprises:
epoxy resin; and
conductive materials in the epoxy resin.

14. The display panel as claimed in claim 11, wherein the sheet further comprises a plurality of openings, and
wherein the connection film further comprises:
an insulation resin having a gray-shade color and provided in the plurality of openings; and
a reflective member comprising a plurality of glass balls and surrounding a lateral surface of the light emitting diode.

15. The display panel as claimed in claim 14, wherein the insulation resin has a luminance property in which a brightness of each of red, green, and blue (RGB) is in a range of 1 < RGB < 100.
